# EUROPÄISCHE PATENTANMELDUNG

(11) **EP 0 911 867 A2**
(43) Veröffentlichungstag der Anmeldung: **28.04.1999**
(21) Anmeldenummer: 98119238.8
(22) Anmeldetag: 12.10.1998
(51) Int. Cl.: H01L 21/00

(54) **Fertigungseinrichtung mit einem Roboter**

(30) Priorität: 24.10.1997 DE 29718996 U
(71) Anmelder: SIEMENS AKTIENGESELLSCHAFT, 80333 München (DE)
(72) Erfinder: Möges, Gerhard, Dipl.-Ing., 90537 Feucht (DE); Seyler, Bernhard, 91729 Haundorf (DE)

(57) **Zusammenfassung**

Leadframes werden in Magazinen (M1-M12) mittels eines längs einer Trasse beweglichen Roboters (R) von und zu Bearbeitungsstationen (B1,B2) verfahren. Dadurch, daß der Roboter (R) jeweils die Magazine (M1-M12) handhabt, sind nur relativ wenige Roboterarmbewegungen nötig. Gemäß der Erfindung weist der Roboter (R) an seinem Fahrgestell (F) Halterungen (H1-H3) für weitere Magazine auf, so daß er ständig einen Magazinvorrat mitführt, wodurch seine Verfahrwege gering gehalten werden können.

## Beschreibung

Die Erfindung bezieht sich auf eine Fertigungseinrichtung, bei der Rohteile von einem fahrbaren Roboter räumlich verteilten Bearbeitungsstation zuführbar sind und diesen als Halbfertig- oder Fertigteile entnehmbar sind, wobei ein Vorrat von Roh-, Halbfertig- und/oder Fertigteilen mit dem Roboter mitführbar ist.

Aus dem "NC/CNC Handbuch 95/96", Hans B. Kief, Karl-Hanser-Verlag München/Wien, Seite 412 ist ein Fertigungssystem dieser Art bekannt, bei dem Bearbeitungsstationen längs eines verfahrbaren Roboters von diesem bedient werden. Dabei sind gesonderte Wagen zur Aufnahme von Rohteilen bzw. Fertigteilen an das Fahrgestell des Roboters angekoppelt. Allerdings muß jedes zu bearbeitende Teil einzeln gehandhabt werden, was relativ häufige Roboterarmbewegungen nachsichzieht.

Aus der EP 0 597 052 B1 ist ein Roboter zum Einsatz in einer Fertigungseinrichtung für Halbleiterbauelemente bekannt, bei dem diese Elemente den einzelnen Bearbeitungsstationen nicht vereinzelt zuzuführen sind; vielmehr erfolgt die Zufuhr so, daß die Roh-, Halbfertig- oder Fertigteile jeweils in Magazinen angeordnet sind, die vom Roboter zur jeweiligen Bearbeitungsstation hin- bzw. zurückgereicht werden. Die Anzahl der Roboterarmbewegungen ist damit stark reduziert, jedoch erweist es sich dabei als ungünstig, daß der mobile Roboter für jedes einzelne Magazin einen Verfahrweg längs seiner Trasse ausführen muß.

Aufgabe der Erfindung ist es, eine Einrichtung der eingangs genannten Art so auszubilden, daß zum einen die Zahl der Lade- bzw. Entladevorgänge der Bearbeitungsmaschine relativ gering ist, daß jedoch auch die Länge und Dauer der Verfahrbewegungen klein gehalten werden kann.

Gemäß der Erfindung wird diese Aufgabe dadurch gelöst, daß die Roh-, Halbfertig- und/oder Fertigteile jeweils in Magazinen vom Roboter mittels eines Magazingreifers an der Roboterspitze zur jeweiligen Bearbeitungsstation hin - oder zurückreichbar sind und daß ein jeweiliger Vorrat an Magazinen mit Roh-, Halbfertig- oder Fertigteilen in Magazinhalterungen unmittelbar seitlich am Fahrgestell des Roboters vorhaltbar ist.

Durch die Zusatzfunktion des Fahrgestells als Träger der Magazinhalterungen kann auf gesonderte, an den Roboter anzukuppelnde Vorratsfahrzeuge verzichtet werden. Die Positionierung außerhalb des Hauptschwenkraums des Roboters ermöglicht diesem auch beiseitig der Trasse angeordnete Bearbeitungsstationen mit kürzesten Schwenkbewegungen zu erreichen.

Eine erste vorteilhafte Ausbildung der Erfindung ist dadurch gekennzeichnet, daß die Magazinhalterungen gleichartig zum Magazingreifer ausgebildet sind. Aufgrund der Variabilität derartiger Greifer können somit auch Magazine unterschiedlicher Größe leicht gehandhabt werden.

Eine weitere vorteilhafte Ausbildung der Erfindung ist dadurch gekennzeichnet, daß durch die Magazinhalterungen die Magazine kraft- und/oder formschlüssig so arretierbar sind, daß diese und die jeweiligen Roh-, Halbfertig- und/oder Fertigteile gegenüber Beschleunigungskräfte gesichert sind.

Ein Ausführungsbeispiel der Erfindung ist in der Zeichnung dargestellt und wird im folgenden näher erläutert. Dabei zeigen:
- FIG 1: die Prinzipdarstellung einer Fertigungseinrichtung und
- FIG 2: den zugehörigen Roboter mit seitlich am Fahrgestell angebrachten Magazinhalterungen.

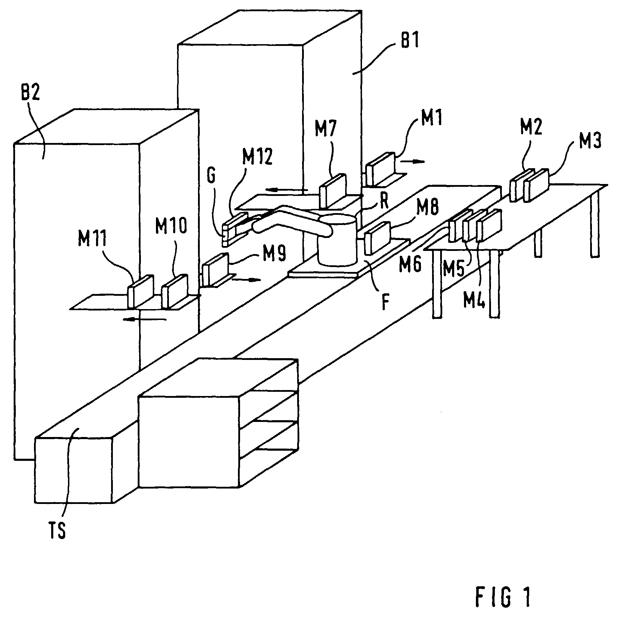

In der Darstellung gemäß FIG 1 ist eine Fertigungseinrichtung für Halbleiter dargestellt. Die Halbleiter mögen dabei auf Systemträgern als sogenannte "Leadframes" angebracht sein. Die Systemträger sind streifenförmig und in Magazine M1 bis M12 einbringbar. Dazu sind die Magazine als Kastenprofile ausgebildet, die an zwei gegenüberliegenden Seiten offen sind. In den Kastenprofilen befinden sich ebenfalls gegenüberliegend Schlitzführungen, in welche die Leadframes waagerecht eingeschoben werden können. Magazine dieser Art, wie sie auch in der EP 0 597 052 B1 beschrieben sind, haben sich seit längerer Zeit im industriellen Einsatz bewährt.

Die Fertigungseinrichtung möge im Ausführungsbeispiel der Einfachheit halber aus Bearbeitungsstationen B1 und B2 bestehen. Die Beschickung dieser Stationen, wie dies beispielsweise durch das Einlagern von Magazinen M7, M10 und M11 angedeutet ist, erfolgt insbesondere mit Hilfe eines auf einem Transportsystem TS mit seinem Fahrgestell F längs einer Trasse verfahrbaren Roboters R, an dessen Roboterspitze ein Magazingreifer G vorgesehen ist. Über bewegliche Transportmittel können weitere Magazine in den Roboterarbeitsraum oder in den Bereich der Bearbeitungsstationen B1 oder B2 zugeführt oder abgeführt werden, was anhand der Magazine M1 und M9 gezeigt ist. Ferner kann eine Übergabestation für Magazine seitlich des Transportsystems TS, ebenfalls für den Roboter R zugänglich, angeordnet sein, wie diese für Magazine M2 bis M6 gezeigt ist.

Wesentlich für die vorliegende Erfindung ist es nun, daß der Roboter R mit seinem Robotergreifer G nicht nur ein einzelnes Magazin, wie dies für ein Magazin M12 beispielhaft gezeigt ist, zu einer der Bearbeitungsstation B1 bzw. B2 führen kann und dann eventuell über längere Verfahrwege sich wieder ein neues Magazin greifen muß, sondern daß unmittelbar am Fahrgestell F des Roboters R auch weitere Magazine, im Ausführungsbeispiel ein Magazin M8, mitgeführt werden können, die damit einen Materialpuffer zur Reduzierung der Verfahrwege längs der Trasse darstellen. (Diese muß nicht unbedingt spurgeführt sein.)

Wenn der Roboter R mit relativ großen Beschleunigungen bewegt wird, ist es erforderlich, ein Fixieren der Leadsframes in den Magazinen M8 und M12 zu gewährleisten. Das kann durch entsprechende Ausbildung des Magazingreifers G, der die offenen Stirnseiten des jeweils gehaltenen Magazins zumindest teilweise abdeckt, geschehen. Ferner müssen auch die jeweils mitgeführten Magazine so in Magazinhalterungen angeordnet sein, daß auch hier ein Herausrutschen der Leadsframes verhindert wird.

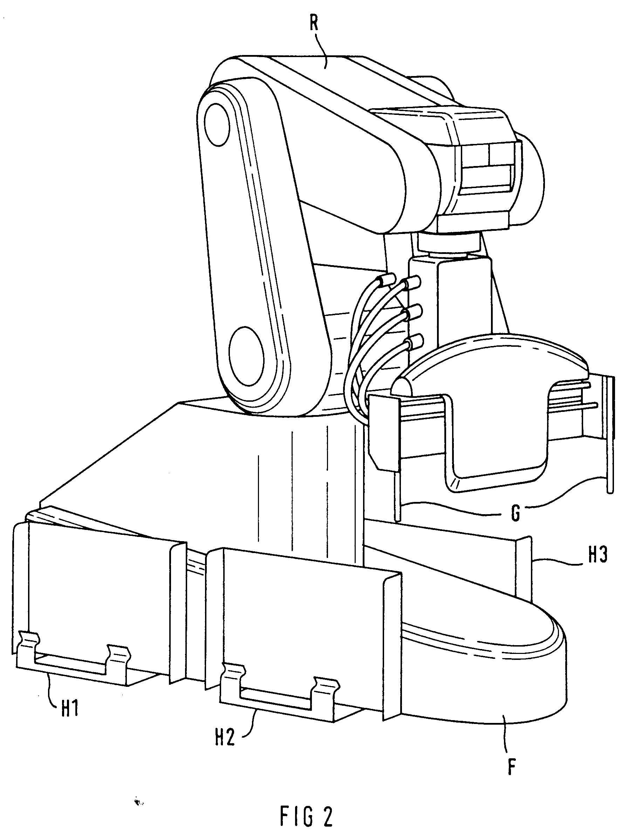

Zur Erläuterung der konstruktiv ausgestalteten Magazinhalterungen sei auf die Darstellung gemäß FIG 2 verwiesen, bei welcher der Roboter R mit seinem Fahrgestell F und seinem Robotergreifer G genauer gezeigt ist. Wesentlich für die vorliegende Erfindung sind dabei seitlich unmittelbar am Fahrgestell symmetrisch angeordnete vier Halterungen, von denen in der Darstellung nur die drei Halterungen H1, H2 und H3 sichtbar sind. Die Halterungen sind dabei als Blechformteile ausgebildet, die jeweils eine Bodenklammer zum Fassen des Bodenbereiches der Magazine aufweisen und die durch ihre seitliche Abwinklungen die freien Öffnungen der Magazine gegen das Herausrutschen der Leadsframes sichern, jedoch den Zugriff mittels des Robotergreifers G erlauben.

Der Umstand, daß die Magazinhalterungen H1 bis H3 direkt am Fahrgestell des Roboters R unterhalb seines gelenkigen Fußpunktes angeordnet sind, ermöglicht ein freies Drehen des Roboterarms und dennoch kurze Zugriffswege zu den Magazinhalterungen.

Anstelle eines stehenden Roboters ist prinzipiell auch eine hängende Roboterkonstruktion möglich.

## Patentansprüche

1. Fertigungseinrichtung, bei der Rohteile von einem fahrbaren Roboter räumlich verteilten Bearbeitungsstationen zuführbar sind und diesen als Halbfertig- oder Fertigteile entnehmbar sind, wobei ein Vorrat von Roh-, Halbfertig- und/oder Fertigteilen mit dem Roboter mitführbar ist, **dadurch gekennzeichnet,** daß die Roh-, Halbfertig- und/oder Fertigteile jeweils in Magazinen (M1 bis M12) vom Roboter (R) mittels eines Magazingreifers (G) an der Roboterspitze zur jeweiligen Bearbeitungsstation (B1,B2) hin- oder zurückreichbar sind und daß ein jeweiliger Vorrat an Magazinen (M8) mit Roh-, Halbfertig- oder Fertigteilen in Magazinhalterungen (H1,H2,H3) unmittelbar am Fahrgestell (F) des Roboters (R) vorhaltbar ist.

2. Fertigungseinrichtung nach Anspruch 1, **dadurch gekennzeichnet,** daß die Magazinhalterungen gleichartig zum Magazingreifer (G) ausgebildet sind.

3. Fertigungseinrichtung nach Anspruch 1 oder 2, **dadurch gekennzeichnet,** daß durch die Magazinhalterungen (H1,H2,H3) die Magazine (M1 bis M12) kraft- und/oder formschlüssig so arretierbar sind, daß diese und/oder die jeweiligen Roh-, Halbfertig- oder Fertigteile gegen Beschleunigungskräfte gesichert sind.
